# FASCICULE DE BREVET EUROPEEN

(11) **EP 3 696 865 B1**
(45) Date de publication et mention de la délivrance du brevet: **25.10.2023**
(21) Numéro de dépôt: 20156051.3
(22) Date de dépôt: 07.02.2020
(51) Int. Cl.: H01L 31/103, H01L 31/0352

(54) **PHOTODIODE**
FOTODIODE
PHOTODIODE

(30) Priorité: 14.02.2019 FR 1901504
(43) Date de publication de la demande: 19.08.2020
(73) Titulaire: STMicroelectronics (Crolles 2) SAS, 38920 Crolles (FR)
(72) Inventeur: RODRIGUES GONCALVES, Boris, 38660 LE TOUVET (FR); TOURNIER, Arnaud, 38000 GRENOBLE (FR)
(74) Mandataire: Cabinet Beaumont

(56) Documents cités:
- EP-A1- 3 188 238
- US-A1- 2015 279 878
- US-B1- 6 538 299

## Description

### Domaine technique

La présente description concerne les photodiodes.

### Technique antérieure

Une photodiode est un composant semiconducteur ayant la capacité de détecter un rayonnement du domaine optique et de le transformer en signal électrique. Plus précisément, la lumière forme des électrons dans la zone active de la photodiode. Ces électrons doivent ensuite être récupérés par un circuit électrique.

Dans un capteur d'images 2D ou 3D comprenant des photodiodes, les électrons formés à un instant donné, lors de la capture d'une scène, sont stockés dans des mémoires, et la quantité d'électrons est ensuite lue par un circuit de manière à obtenir une information sur la scène.

Pour que l'information sur la scène soit précise et corresponde à l'instant donné, il est préférable que les électrons se déplacent rapidement vers les mémoires.

Le document US6538299 B1 divulgue un exemple de photodiode connue présentant une collection de porteurs par peignes interdigités.

### Résumé de l'invention

L'invention est définie dans les revendications ci-jointes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, par une vue de dessus et une vue en coupe, un mode de réalisation d'une photodiode ;
la figure 2 représente le potentiel V dans la photodiode de la figure 1 en fonction de la position dans la photodiode du mode de réalisation de la figure 1 ;
la figure 3 représente, par une vue de dessus, un autre mode de réalisation d'une photodiode ;
la figure 4 représente un autre mode de réalisation d'une photodiode ; et
la figure 5 représente le potentiel V dans la photodiode de la figure 4 en fonction de la position dans la photodiode du mode de réalisation de la figure 4.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications des photodiodes ne seront pas détaillées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Une solution pour augmenter la rapidité du mouvement des électrons en direction des mémoires est la formation d'un champ électrique dans la photodiode, par exemple en appliquant une tension graduelle à la photodiode, la tension étant plus faible loin du contact et plus forte près du contact.

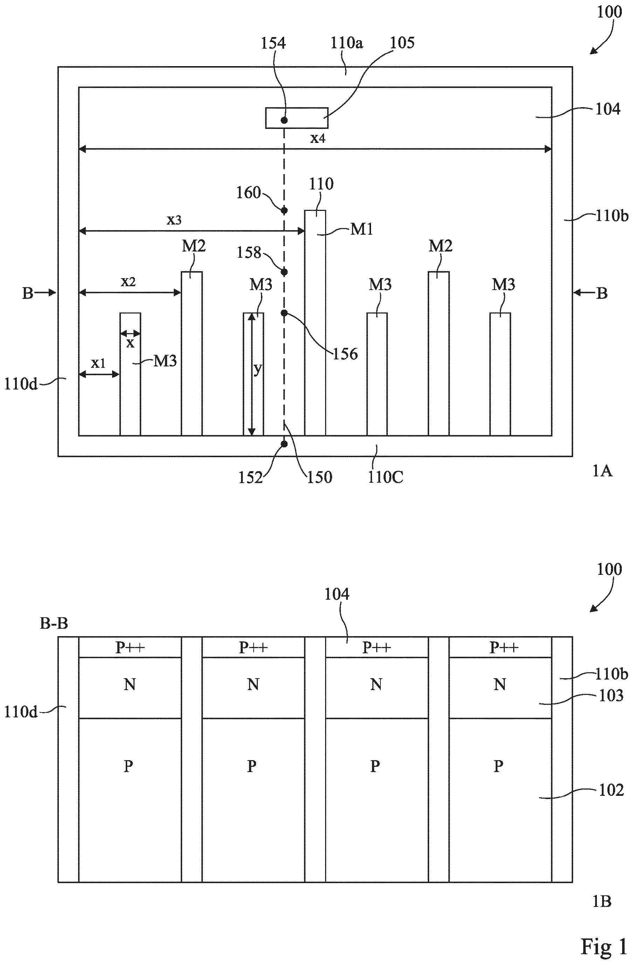

La figure 1 représente, par une vue de dessus (1A) et une vue en coupe (1B) selon le plan B-B de la vue 1A, un mode de réalisation d'une photodiode 100.

La photodiode 100 est située dans un substrat semiconducteur, par exemple en silicium et comprend une jonction PN. La jonction PN comprend une couche semiconductrice 102 de type P recouverte d'une couche semiconductrice 103 de type N. La couche 103 est par exemple recouverte d'une couche semiconductrice 104 fortement dopée P (P++). Les couches semiconductrices 102, 103 et 104 sont par exemple en silicium.

La photodiode 100 comprend un plot de connexion 105. Le plot 105 permet par exemple une connexion entre la photodiode 100 et d'autres composants électriques, par exemple un système d'échantillonnage pouvant comprendre des grilles de transfert, des mémoires ou encore des régions semiconductrices de type N formant des noeuds. Le plot 105 correspond donc à une des bornes de la photodiode, par exemple à la photodiode.

La figure 1 ne représente qu'un seul plot 105. En pratique, la photodiode 100 peut comprendre plusieurs plots 105. Par exemple, deux plots 105 peuvent être situés sur la couche 104.

La photodiode 100 comprend des murs 110, ou tranchées, s'étendant sur toute la hauteur de la photodiode. Dans la suite de ce texte, on entend par mur ou tranchée une structure en un matériau semiconducteur, par exemple en silicium. Par exemple, les murs 110 s'étendent au moins de la face supérieure de la couche 103 à la face inférieure de la couche 102. De préférence, les murs 110 traversent les couches semiconductrices formant la photodiode. De préférence, les murs 110 s'étendent à travers tout le substrat semiconducteur dans lequel est formée la photodiode 110. Dans l'exemple de la figure 1, les murs traversent aussi la couche 104.

Les murs 110 incluent des murs externes, entourant, dans l'exemple de la figure 1, entièrement la photodiode. Plus précisément, la photodiode 100 est entourée par les murs externes 110a, 110b, 110c et 110d. Les murs 110a et 110c sont par exemple sensiblement parallèles. De même, les murs latéraux 110b et 110d sont par exemple sensiblement parallèles. Les murs 110a et 110c sont par exemple sensiblement perpendiculaires avec les murs 110b et 110d.

Le mur 110a est par exemple le mur le plus proche du ou des plots de connexion 105, parmi les murs 110a, 110b, 110c et 110d. Le plot de connexion 105 représenté en figure 1 est par exemple situé sensiblement à égale distance des murs 110b et 110d.

Lorsque la photodiode 100 comprend plusieurs plots 105, les plots 105 peuvent par exemple former une ligne parallèle aux murs 110a et 110c.

Les murs 110 comprennent, en plus des murs externes 110a, 110b, 110c et 110d, des murs internes ou centraux, sensiblement parallèles aux murs 110b et 110d, s'étendant à partir du mur 110c. Les murs internes et les murs 110b et 110d forment les branches d'une structure en forme de peigne. Les branches sont, dans l'exemple de la figure 1, interconnectées par le mur 110c. Ainsi, les murs internes et externes sont interconnectés et reçoivent de préférence un même potentiel électrique.

Dans l'exemple de la figure 1, le peigne comprend neuf murs, y compris les murs 110b et 110d. De préférence, le peigne comprend un nombre impair de murs.

Le peigne de la figure 1 comprend :
- un premier mur interne M1 (d'un rang 1), le plus long parmi les murs internes ;
- deux deuxièmes murs interne M2 (d'un rang 2), chaque deuxième mur ayant, de préférence, une longueur sensiblement égale à 3/4 de la longueur du premier mur M1 ;
- quatre troisièmes murs interne M3 (d'un rang 3), chaque troisième mur ayant, de préférence, une longueur y sensiblement égale à 3/4 de la longueur des deuxièmes murs.

Par longueur, on entend la plus grande dimension en vue de dessus, c'est-à-dire dans la vue de la figure 1.

Par exemple, le plot 105 est situé dans la partie de la photodiode entre le mur 110a et l'extrémité du mur M1. Le plot 105 est de préférence en regard de l'extrémité du mur M1. De préférence, le plot 105 est situé entre les murs externes. De préférence, le plot 105 n'est pas séparé des murs externes 110b et 110d par un ou plusieurs murs centraux.

Chaque mur interne 110 est compris entre deux murs de longueur supérieure. Dans l'exemple de la figure 1, le mur M1 est compris entre les murs 110b et 110d. Chaque mur M2 est, dans cet exemple, compris entre le mur M1 et un des murs externes 110b, 110d. Chaque mur M3 est, dans cet exemple, compris entre un des murs M2 et le mur M1 ou entre un des murs M2 et un des murs externes 110b, 110d.

Plus généralement, le peigne comprend au moins les murs latéraux 110b et 110d (ou murs M0) et au moins le mur central M1. Le peigne comprend n rangs de murs M1 à Mn, dans lequel n est un entier supérieur ou égal à 1, et de préférence inférieur ou égal à 3. Le peigne comprend, de préférence, 2^(i-1) murs Mi du rang i (^ représentant la fonction puissance), avec i un entier compris entre 1 et n. La longueur de chaque mur Mi de rang i, avec i un entier compris entre 1 et n, est inférieure aux longueurs des murs de rang inférieur à i. De plus, chaque mur central est situé entre deux murs de rang inférieur, dont un mur de rang immédiatement inférieur, c'est-à-dire que chaque mur central Mi de rang i, avec i un entier compris entre 1 et n, est situé entre deux murs de rang inférieurs à i, un de ces deux murs étant un mur de rang i-1.

La longueur de chaque mur Mi de rang i est, de préférence, sensiblement égale à 3/4 de la longueur des murs Mi-1, pour i compris entre 2 et n. Chaque mur Mi-1 de rang i-1, avec i un entier entre 2 et n, est situé entre un mur Mj et un mur Mk, j et k étant des entiers inférieurs à i, j et k pouvant être égaux au même entier.

Les murs 110 ont, par exemple, tous une même largeur x, la largeur étant la plus petite dimension des murs en vue de dessus (vue 1A), par exemple comprise entre environ 100 nm et environ 300 nm. Chaque mur est par exemple séparé des murs les plus proches par une distance x1 sensiblement égale à 5*x (* représente une multiplication).

Dans l'exemple de la figure 1, les murs M2 sont séparés des murs 110b ou 110d et du mur M1 par une distance x2 sensiblement égale à 11*x. Le mur M1 est séparé des murs latéraux 110b et 110d par une distance x3, sensiblement égale à 23*x. Les murs latéraux 110b et 110d sont séparés d'une distance x4 sensiblement égale à 47*x.

Les murs les moins longs, c'est-à-dire les murs Mn (M3 en figure 1), ont par exemple une longueur, en vue de dessus comprise entre 200 nm et 1500 nm. De préférence, les murs d'un même rang ont sensiblement la même longueur, en vue de dessus.

Les murs 110 centraux et externes sont connectés à une source de tension négative, par exemple sensiblement inférieure à -1 V. Par exemple, une même tension négative est appliquée à tous les murs 110, les murs 110 étant interconnectés.

La tension négative appliquée aux murs entraine la formation d'un potentiel électrostatique graduel dans la photodiode. Plus précisément, le potentiel électrostatique est plus faible dans les parties de la photodiode où les murs sont les plus proches (au niveau des murs Mn) qu'au niveau du plot 105, autour duquel il n'y a pas de murs internes Mi. Le champ électrique produit par ce gradient de potentiel, de préférence sensiblement constant, permet le déplacement plus rapide des électrons formés par la photodiode. En particulier, le champ électrique permet le déplacement plus rapide des électrons formés par la photodiode vers le ou les plots 105.

A titre de variante, les murs situés sensiblement perpendiculairement aux murs internes Mi peuvent ne pas être formés. Ainsi, les murs externes peuvent n'entourer que partiellement la zone active de la photodiode. Par exemple, le mur 110a et/ou le mur 110c peuvent ne pas être présents. Si le mur 110c est absent, les murs internes sont alors reliés par d'autres moyens à un noeud d'application de la tension négative, de préférence à un même noeud d'application de la tension négative.

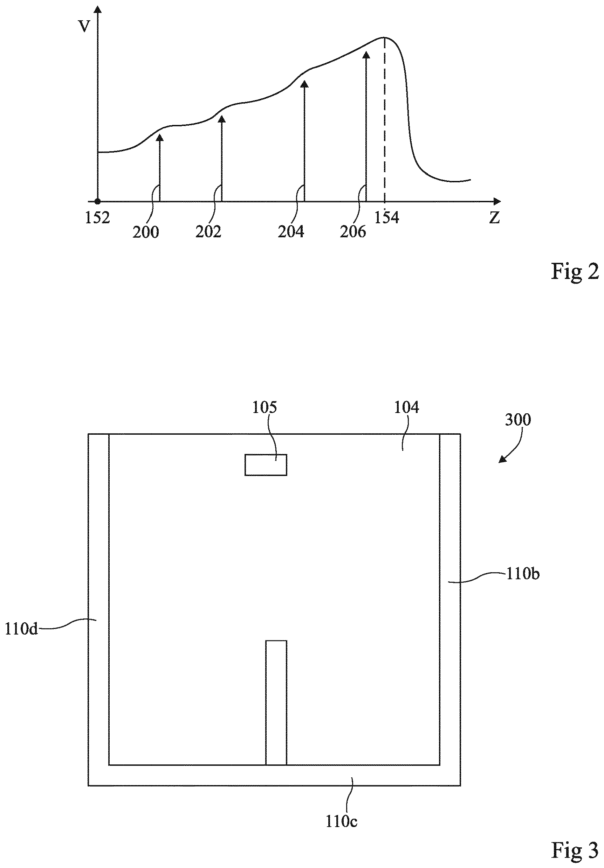

La figure 2 représente un exemple de variations d'un potentiel V dans la photodiode, en fonction de la position (Z) sur un chemin 150 (figure 1) commençant en un point 152 (figure 1), dans le mur 110c, et se terminant dans une mémoire (non représentée), par l'intermédiaire du plot de connexion 105 (figure 1).

L'origine de l'axe des abscisses correspond au point 152 situé dans du mur 110c.

La figure 2 comprend des flèches 200, 202, 204 et 206. Chaque flèche correspond au passage dans une région différente de la photodiode 100.

La flèche 200 correspond au passage dans une première région, délimitée, sur le chemin 150, par le mur 110c d'un côté et un point 156 de l'autre (figure 1). Plus précisément, la première région s'étend du mur 110c à l'extrémité des murs M3. Il s'agit de la région dans laquelle un électron se situe toujours à une distance inférieure à la distance x1 d'un mur. Le potentiel V dans la première région est plus important que dans le mur 110c et augmente en se rapprochant du point 156.

La flèche 202 correspond au passage dans une deuxième région, délimitée, sur le chemin 150, par le point 156 d'un côté et un point 158 de l'autre (figure 1). Plus précisément, la deuxième région s'étend de l'extrémité des murs M3 à l'extrémité des murs M2. Il s'agit de la région dans laquelle un électron se situe toujours à une distance inférieure à la distance x2 d'un mur. Le potentiel V dans la deuxième région est plus important que dans la première région et augmente en se rapprochant du point 158.

La flèche 204 correspond au passage dans une troisième région, délimitée, sur le chemin 150, par le point 158 d'un côté et un point 160 de l'autre (figure 1). Plus précisément, la troisième région s'étend de l'extrémité des murs M2 à l'extrémité du mur M1. Il s'agit de la région dans laquelle un électron se situe toujours à une distance inférieure à la distance x3 d'un mur. Le potentiel V dans la troisième région est plus important que dans la deuxième région et augmente en se rapprochant du point 160.

La flèche 206 correspond au passage dans une quatrième région, délimitée, sur le chemin 150, par le point 160 d'un côté et un point 154 de l'autre (figure 1). Plus précisément, la quatrième région s'étend de l'extrémité du mur M1 au plot 105. Il s'agit de la région dans laquelle un électron se situe toujours à une distance inférieure à la distance x4 d'un mur. Le potentiel V dans la quatrième région est plus important que dans la troisième région et augmente en se rapprochant du point 154.

Ainsi, le potentiel V dans la photodiode, représentatif du champ électrique présent dans la photodiode, est graduel entre le point 152 et le point 154, augmentant lorsque l'on se rapproche du mur 110a et du plot 105.

La chute du potentiel V après le point 154 correspond au passage dans le système d'échantillonnage.

La figure 3 représente, par une vue de dessus, un autre mode de réalisation d'une photodiode 300.

La photodiode 300 comprend, comme la photodiode 100 de la figure 1, une couche 103 dopée de type N (non représentée), une couche 102 dopée de type P (non représentée) et une couche 104 fortement dopée de type P++. De plus, la photodiode comprend les murs 110b, 110c et 110d. Le mur 110a n'est pas présent dans l'exemple de la figure 3.

La photodiode 300 ne comprend, en plus des murs M0 110b et 110d, que le mur M1. Les murs 110 (M0 et M1) s'étendent sur toute la hauteur de la photodiode 300, comme cela a été décrit pour les murs 110 de la figure 1.

La photodiode 300 comprend, de plus, un ou plusieurs plots de connexion 105, tels qu'ils ont été décrits précédemment. Un seul plot 105 est représenté en figure 3. En pratique, plusieurs plots 105 peuvent être situés sur la photodiode 300.

Dans le cas du mode de réalisation de la figure 3, la variation de potentiel entre le mur 110c et le ou les plots de connexion 105 est plus irrégulière que dans le mode de réalisation de la figure 1. Ainsi, l'accélération causée par le champ électrique est moins importante. Cependant, le seul mur M1 coute moins de surface dans la zone active de la photodiode que les murs M1, M2 et M3 du mode de réalisation de la figure 1.

De manière plus générale, l'augmentation de l'entier n correspondant au nombre de rangs de murs entraine une continuité dans la variation du potentiel V, c'est-à-dire une variation plus régulière du potentiel V. Cette continuité entraine aussi une perte de surface dans la zone active de la photodiode. Cependant, cette perte de surface est au moins partiellement compensée par les murs 110. En effet, les murs 110 traversent la photodiode et accélèrent donc le mouvement d'électrons situés sur toute la hauteur de la photodiode, y compris des électrons qui n'aurait pas été attiré par les plots de connexion 105 en absence du champ électrique provoqué par les murs 110. Le rendement de la photodiode est donc augmenté.

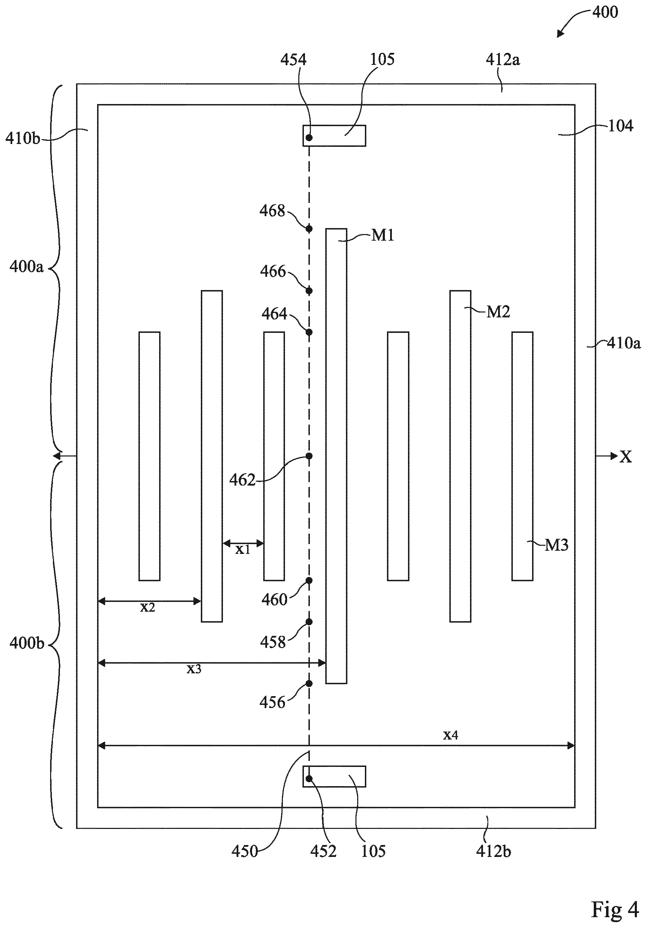

La figure 4 illustre un autre mode de réalisation d'une photodiode 400.

La photodiode comprend deux parties 400a et 400b. Chacune des parties 400a et 400b est similaire à la photodiode 100 de la figure 1, à l'exception du mur 100c. Les parties 400a et 400b sont symétriques par rapport à un axe X situé entre les parties 400a et 400b, à l'emplacement, pour chaque partie, où était situé le mur 110c.

La photodiode 400 comprend donc, comme la photodiode 100 de la figure 1 et la photodiode 300 de la figure 3, une couche 103 dopée de type N (non représentée), une couche 102 dopée de type P (non représentée) et une couche 104 fortement dopée de type P++.

La photodiode comprend des murs externes 410a, 410b, 412a et 412b. Les murs 412a et 412b correspondent aux murs 110a de chaque partie 400a et 400b. L'axe X est par exemple sensiblement à égale distance des murs 412a et 412b.

La photodiode 400 comprend, de plus, des murs latéraux 410a et 410b. Les murs 410a et 410b correspondent aux murs 110b et 110d des parties 400a et 400b.

Les murs 410a et 410b sont par exemple sensiblement parallèles l'un à l'autre. De la même manière, les murs 412a et 412b sont par exemple sensiblement parallèles l'un à l'autre. Les murs 410a et 410b sont par exemple sensiblement perpendiculaires aux murs 412a et 412b.

Comme les murs 110a et 110c des modes de réalisation précédents, les murs 412a et 412b peuvent ne pas être présents.

La photodiode 400 comprend, dans cet exemple, deux plots de connexion 105. Un plot de connexion 105 est situé au niveau du mur 412a et un autre plot de connexion 105 est situé au niveau du mur 412b, de la même manière qu'un plot de connexion était situé au niveau du mur 110a dans le mode de réalisation de la figure 1. Chaque plot de connexion est par exemple situé sensiblement à égale distance des murs 410a et 410b. Par exemple, chaque plot 105 est situé dans la partie de la photodiode entre un mur 412a ou 412b et une des extrémités du mur M1.

A titre de variante, la photodiode peut comprendre un nombre plus élevé de plots de connexion 105, comme cela a été mentionné en relation avec la figure 1.

La photodiode 400 comprend, de plus, les murs centraux M1 à Mn. Les murs centraux M1 à Mn s'étendent par exemple depuis l'axe X vers les murs 412a et 412b. De préférence, la longueur de chaque mur central est sensiblement égale dans chacune des parties 400a et 400b.

Les murs centraux ne sont pas, dans cet exemple, interconnectés par un mur 110c, comme en figure 1. Cependant, les murs 410a, 410b et les murs centraux forment les branches d'un peigne.

Ainsi, comme la photodiode 100 de la figure 1, la photodiode 400 comprend :
- un premier mur M1, le plus long parmi les murs centraux ;
- deux deuxièmes murs M2, chaque deuxième mur ayant, de préférence, une longueur sensiblement égale à 3/4 de la longueur du premier mur M1 ;
- quatre troisièmes murs M3, chaque troisième mur ayant, de préférence, une longueur sensiblement égale à 3/4 de la longueur des deuxièmes murs.

Chaque mur central est compris entre deux murs de longueur supérieure. Dans l'exemple de la figure 4, le mur M1 est compris entre les murs 410a et 410b, chaque mur M2 est compris entre le mur M1 et un des murs externes 410a, 410b, chaque mur M3 est compris entre un des murs M2 et le mur M1 ou entre un des murs M2 et un des murs externes 410a, 410b.

Plus généralement, la photodiode 400 comprend au moins les murs latéraux 410a et 410b (ou murs M0) et au moins le mur central M1. La photodiode 400 comprend n rangs de murs M1 à Mn, dans lequel n est un entier supérieur ou égal à 1, et de préférence inférieure à 3. La photodiode 400 comprend, de préférence, 2^(i-1) murs Mi (^ représentant la fonction puissance), avec i un entier compris entre 1 et n. La longueur de chaque mur Mi de rang i est, de préférence, sensiblement égale à 3/4 de la longueur des murs Mi-1 de rang i-1, pour i compris entre 2 et n. Chaque mur Mi, avec i un entier entre 1 et n, est situé entre un mur Mj et un mur Mk, j et k étant des entiers inférieurs à i.

Les murs 110, c'est-à-dire les murs centraux Mi, ont, par exemple, tous une même largeur x, la largeur étant la plus petite dimension en vue de dessus, par exemple comprise entre environ 100 nm et environ 300 nm. Les murs sont par exemple séparés des murs adjacents par une distance x1 sensiblement égale à 5*x (* représente une multiplication).

Dans l'exemple de la figure 4, les murs M2 sont séparés des murs 410a ou 410b et du mur M1 par une distance x2 sensiblement égale à 11*x. Le mur M1 est séparé des murs latéraux 410a ou 410b par une distance x3, sensiblement égale à 23*x. Les murs latéraux 410a et 410b sont séparés d'une distance x4 sensiblement égale à 47*x.

Les murs les moins longs, c'est-à-dire les murs Mn (M3 en figure 1), ont par exemple une longueur comprise entre 400 et 3000 nm.

Les murs centraux sont connectés à une source de tension négative, par exemple sensiblement inférieure à -1 V. Par exemple, une même tension négative est appliquée à tous les murs centraux. Les murs M1 à Mn et les murs externes 410a, 410b, 412a et 412b sont par exemple reliés les uns aux autres par l'intermédiaire d'éléments de connexion non représentés, par exemple un ou plusieurs niveaux de métallisation et des vias conducteurs, ou des fils conducteurs.

La tension négative appliquée aux murs 110 entraine la formation d'un potentiel électrostatique graduel dans la photodiode. Plus précisément, le potentiel électrostatique est plus faible dans les parties de la photodiode 400 où les murs sont les plus proches (au niveau des murs Mn) qu'au niveau des plots 105, autour desquels il n'y a pas de murs internes Mi. Le champ électrique produit par ce potentiel électrostatique permet le déplacement plus rapide des électrons formés par la photodiode d'un côté ou de l'autre de la photodiode.

A titre de variante, les murs situés sensiblement perpendiculairement aux murs internes Mi peuvent ne pas être formés. Par exemple, le mur 412a et/ou le mur 412b peuvent ne pas être présents.

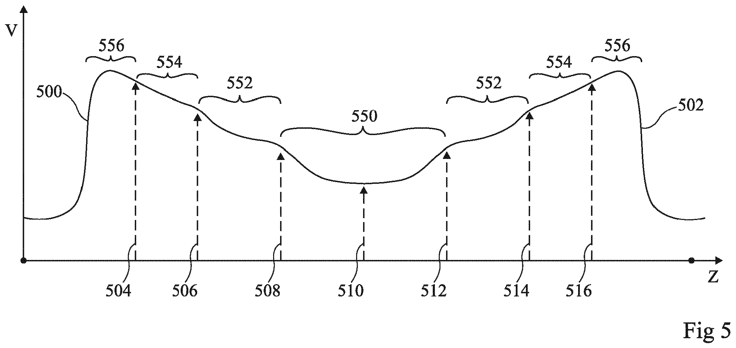

La figure 5 représente un exemple de variations d'un potentiel V, en fonction de la position sur un chemin 450 (figure 4) commençant en un premier point de collecte des électrons, par exemple une première mémoire et terminant dans un deuxième point de collecte des électrons, par exemple une deuxième mémoire, par l'intermédiaire des plots de connexion 105, représentés par les points 452 et 454 du chemin 450 (figure 4). L'origine de l'axe des abscisses correspond donc à la première mémoire.

Les variations sont similaires aux variations décrites en relation avec la figure 2 pour chaque partie 400a et 400b.

La figure 5 comprend des flèches 504, 506, 508, 510, 512, 514 et 516. Chaque flèche correspond au passage dans une région différente de la photodiode 400.

La flèche 510 représente le point 462 situé au croisement entre le chemin 450 et l'axe X de symétrie de la photodiode 400. Les électrons situés entre le point 462 et le mur 412a vont se diriger vers le point 454. Les électrons situés entre le point 462 et le mur 412b vont se diriger vers le point 452.

La zone 550 entre les flèches 508 et 512 correspond aux variations de potentiel entre les points 460 (figure 4) et 464 (figure 4), c'est-à-dire dans une première région dans laquelle un électron se situe toujours à une distance inférieure à la distance x1 d'un mur. Le potentiel V dans la première région est plus important augmente en se rapprochant des point 460 et 464.

Les flèches 508 et 512 correspondent aux passages dans des deuxièmes régions situées, sur le chemin 150, entre les points 460 et 458 pour l'une et entre les points 464 et 466 pour l'autre (figure 4). Il s'agit des régions de la photodiode 400, représentés par les zones 552, dans lesquelles un électron se situe toujours à une distance inférieure à la distance x2 d'un mur. Le potentiel V dans les deuxièmes régions est plus important que dans la première région et augmente en se rapprochant des points 458 et 466.

Les flèches 506 et 514 correspondent aux passages dans des troisièmes régions situées, sur le chemin 150, entre les points 458 et 456 pour l'une et entre les points 466 et 468 pour l'autre (figure 4). Il s'agit des régions de la photodiode 400, représentés par les zones 554, dans lesquelles un électron se situe toujours à une distance inférieure à la distance x3 d'un mur. Le potentiel V dans les troisièmes régions est plus important que dans les deuxièmes régions et augmente en se rapprochant des points 456 et 468.

Les flèches 504 et 516 correspondent aux passages dans des quatrièmes régions situées, sur le chemin 150, entre les points 456 et 452 pour l'une et entre les points 468 et 454 pour l'autre (figure 4). Il s'agit des régions de la photodiode 400, représentés par les zones 556, dans lesquelles un électron se situe toujours à une distance inférieure à la distance x4 d'un mur. Le potentiel V dans les quatrièmes régions est plus important que dans les troisièmes régions et augmente en se rapprochant des points 452 et 454.

Ainsi, le potentiel V dans la photodiode 400, représentatif du champ électrique, est graduel entre le point 462 et les points 452 et 454, augmentant lorsque l'on se rapproche des murs 412a et 412b. Cela permet l'augmentation de la vitesse des électrons vers l'un ou l'autre des plots de connexion.

La montée importante 500 et la chute importante 502 de potentiel représentent les passages dans les mémoires, par l'intermédiaire des plots de connexion 105.

On aurait pu choisir de déposer de multiples électrodes sur la surface de la photodiode, chaque électrode étant à un potentiel différent de manière à former le champ électrique voulu. Cependant, une telle structure nécessite d'obtenir les différentes tensions, et nécessite donc un circuit complexe de gestion de puissance. De plus, une telle structure est couteuse en énergie.

Un avantage des modes de réalisation décrits ici est qu'une seule tension est fournie aux murs 110. Ainsi, la mise en oeuvre de la gestion de puissance des modes de réalisation décrits est donc simple.

On aurait aussi pu choisir la forme de la photodiode de telle manière que la photodiode ait, en vue de dessus, une largeur diminuant selon une courbe arrondie lorsque l'on s'éloigne d'un plot de connexion 105. Cela aurait permis de former un potentiel électrostatique graduel dans la photodiode. Cependant, cela impliquerait la formation d'une photodiode ayant une forme complexe dont la fabrication n'est pas aisée. De plus, cela entrainerait des limitations importantes sur la forme et les dimensions des photodiodes.

Un avantage des modes de réalisation décrits est que les murs sont en contact avec les couches semiconductrices 102 et 103 sur toute leur hauteur. Ainsi, le champ électrique est situé, de même, sur l'ensemble du volume de la photodiode. La vitesse des électrons est donc accélérée quel que soit leur position dans la photodiode. Cela n'est pas le cas dans les exemples où la tension négative n'est appliquée que sur la face supérieure de la photodiode.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les types de dopages N et P peuvent être inversés.

Enfin, la mise en oeuvre pratique des modes de réalisation et variantes décrits est à la portée de l'homme du métier à partir des indications fonctionnelles données ci-dessus.

## Revendications

1. Photodiode (100, 300, 400) comprenant une première couche semiconductrice (102) dopée de type P recouverte d'une deuxième couche semiconductrice (103) de type N, les première et deuxième couches formant une jonction PN, la photodiode comprenant deux murs semiconducteurs latéraux (110b, 110d ; 410a, 410b) dits de rang zéro (M0) et au moins un mur semiconducteur interne (M1, M2, M3, Mi, Mn), les murs internes et latéraux s'étendant sur toute la hauteur des première et deuxième couches semiconductrices, les murs latéraux et internes formant les branches d'une structure en forme de peigne et étant interconnectés de manière à recevoir un même potentiel électrique, chaque mur semiconducteur interne étant situé entre deux murs de longueur supérieure, la photodiode comprend n rangs de murs internes (M1, M2, M3, Mi, Mn), n étant un entier supérieur ou égal à 1, chaque mur interne (M1, M2, M3, Mi, Mn) a une longueur inférieure aux longueurs des murs de rang inférieur, chaque mur interne (M1, M2, M3, Mi, Mn) est situé entre deux murs de rang inférieur, un de ces murs étant de rang immédiatement inférieur, les murs internes d'un même rang ayant sensiblement la même longueur en vue de dessus.

2. Photodiode selon la revendication 1, dans laquelle les murs latéraux (110b, 110d ; 410a, 410b) et le au moins un mur interne (M1, M2, M3, Mi, Mn) s'étendent sur toute la hauteur de la photodiode (100, 300, 400).

3. 4. Photodiode selon l'une quelconque des revendications 1 à 2, comprenant 2^(i-1) murs internes (M1, M2, M3, Mi, Mn) du rang i, i étant un entier entre 1 et n.

4. Photodiode selon l'une quelconque des revendications 1 à 3, dans laquelle les murs internes (M1, M2, M3, Mi, Mn) du rang i, i étant un entier compris entre 2 et n, ont une longueur sensiblement égale à 3/4 de la longueur des murs internes (M1, M2, M3, Mi, Mn) du rang i-1.

5. Photodiode selon l'une quelconque des revendications 1 à 4, dans laquelle une tension négative est appliquée aux murs internes (M1, M2, M3, Mi, Mn) et latéraux (110b, 110d ; 410a, 410b).

6. Photodiode selon l'une quelconque des revendications 1 à 5, dans laquelle des murs semiconducteurs externes (110a, 110b, 110c, 110d ; 410a, 410b, 412a, 412b), incluant les murs latéraux, entourent au moins partiellement la zone active de la photodiode (100, 300, 400).

7. Photodiode selon la revendication 6, dans laquelle les murs internes (M1, M2, M3, Mi, Mn) sont interconnectés par un des murs externes (110c).

8. Photodiode selon la revendication 6 ou 7, dans laquelle les murs externes (110a, 110b, 110c, 110d ; 410a, 410b, 412a, 412b) entourent entièrement la zone active de la photodiode (100, 300, 400).

9. Photodiode selon l'une quelconque des revendications 1 à 8, dans laquelle les murs internes et latéraux ont une largeur, en vue de dessus, comprise entre environ 100 et environ 300 nm.

10. Photodiode selon l'une quelconque des revendications 1 à 9, dans laquelle les murs internes sont séparés de murs internes ou latéraux les plus proches d'une distance égale à sensiblement cinq fois leur largeur, en vue de dessus.

## Patentansprüche

1. Fotodiode (100, 300, 400) mit einer ersten dotierten Halbleiterschicht (102) vom P-Typ, die von einer zweiten Halbleiterschicht (103) vom N-Typ bedeckt ist, wobei die erste und die zweite Schicht einen PN-Übergang bilden und die Fotodiode zwei seitliche Halbleiterwände (110b, 110d; 410a, 410b), die den Rang Null haben, und mindestens eine innere Halbleiterwand (M1, M2, M3, Mi, Mn), wobei sich die innere und die seitlichen Wände über die gesamte Höhe der ersten und der zweiten Halbleiterschicht erstrecken, wobei die seitlichen und die inneren Wände die Zweige einer kammförmigen Struktur bilden und so miteinander verbunden sind, dass sie dasselbe elektrische Potential erhalten, wobei jede innere Halbleiterwand zwischen zwei Wänden größerer Länge liegt, die Fotodiode n Reihen von inneren Wänden (M1, M2, M3, Mi, Mn) aufweist, wobei n eine ganze Zahl größer oder gleich 1 ist, jede innere Wand (M1, M2, M3, Mi, Mn) eine Länge aufweist, die geringer ist als die Längen der Wände der unteren Reihe, jede innere Wand (M1, M2, M3, Mi, Mn) zwischen zwei Wänden der unteren Reihe angeordnet ist, wobei eine dieser Wände der unmittelbar unteren Reihe angehört, wobei die inneren Wände einer gleichen Reihe von oben betrachtet im Wesentlichen die gleiche Länge aufweisen.

2. Fotodiode nach Anspruch 1, wobei sich die Seitenwände (110b, 110d; 410a, 410b) und die mindestens eine Innenwand (M1, M2, M3, Mi, Mn) über die gesamte Höhe der Fotodiode (100, 300, 400) erstrecken.

3. Fotodiode nach einem der Ansprüche 1 bis 2, mit 2^(i-1) Innenwänden (M1, M2, M3, Mi, Mn) der Reihe i, wobei i eine ganze Zahl von 1 bis n ist.

4. Fotodiode nach einem der Ansprüche 1 bis 3, wobei die Innenwände (M1, M2, M3, Mi, Mn) der Reihe i, wobei i eine ganze Zahl zwischen 2 und n ist, eine Länge aufweisen, die im Wesentlichen gleich 3/4 der Länge der Innenwände (M1, M2, M3, Mi, Mn) der Reihe i-1 ist.

5. Fotodiode nach einem der Ansprüche 1 bis 4, wobei eine negative Spannung an die inneren (M1, M2, M3, Mi, Mn) und seitlichen (110b, 110d; 410a, 410b) Wände angelegt wird.

6. Fotodiode nach einem der Ansprüche 1 bis 5, wobei äußere Halbleiterwände (110a, 110b, 110c, 110d; 410a, 410b, 412a, 412b), einschließlich lateraler Wände, die aktive Zone der Fotodiode (100, 300, 400) zumindest teilweise umgeben.

7. Fotodiode nach Anspruch 6, wobei die Innenwände (M1, M2, M3, Mi, Mn) durch eine der Außenwände (110c) miteinander verbunden sind.

8. Fotodiode nach Anspruch 6 oder 7, wobei die Außenwände (110a, 110b, 110c, 110d; 410a, 410b, 412a, 412b) die aktive Zone der Fotodiode (100, 300, 400) vollständig umgeben.

9. Fotodiode nach einem der Ansprüche 1 bis 8, wobei die inneren und seitlichen Wände eine Breite aufweisen, die, von oben betrachtet, im Bereich von etwa 100 und etwa 300 nm liegt.

10. Fotodiode nach einem der Ansprüche 1 bis 9, wobei die inneren Wände von den nächstgelegenen inneren oder seitlichen Wänden durch einen Abstand getrennt sind, der, von oben gesehen, im Wesentlichen dem Fünffachen ihrer Breite entspricht.

## Claims

1. Photodiode (100, 300, 400) comprising a first P-type doped semiconductor layer (102) covered by a second N-type semiconductor layer (103), the first and second layers forming a PN junction, the photodiode comprising two lateral semiconductor walls (110b, 110d; 410a, 410b) said to be of rank zero, and at least one inner semiconductor wall (M1, M2, M3, Mi, Mn), the inner and lateral walls extending along the entire height of the first and second semiconductor layers, the lateral and inner walls forming the branches of a comb-shaped structure, and being interconnected so as to receive the same electrical potential, each inner semiconductor wall being located between two walls of greater length, the photodiode comprises n rows of inner walls (M1, M2, M3, Mi, Mn), n being an integer greater than or equal to 1, each inner wall (M1, M2, M3, Mi, Mn) has a length less than the lengths of the walls of lower row, each inner wall (M1, M2, M3, Mi, Mn) is located between two walls of lower row, one of these walls being of immediately lower row, the inner walls of a same row having substantially the same length when viewed from above.

2. Photodiode according to claim 1, wherein the lateral walls (110b, 110d; 410a, 410b) and the at least one inner wall (M1, M2, M3, Mi, Mn) extend along the entire height of the photodiode (100, 300, 400).

3. Photodiode according to any one of claims 1 to 2, comprising 2^(i-1) inner walls (M1, M2, M3, Mi, Mn) of the row i, i being an integer ranging from 1 to n.

4. Photodiode according to any one of claims 1 to 3, wherein the inner walls (M1, M2, M3, Mi, Mn) of the row i, i being an integer ranging from 2 to n, have a length substantially equal to 3/4 of the length of the inner walls (M1, M2, M3, Mi, Mn) of the row i-1.

5. Photodiode according to any one of claims 1 to 4, wherein a negative voltage is applied to the inner (M1, M2, M3, Mi, Mn) and lateral (110b, 110d; 410a, 410b) walls.

6. Photodiode according to any one of claims 1 to 5, wherein outer semiconductor walls (110a, 110b, 110c, 110d; 410a, 410b, 412a, 412b), including lateral walls, at least partially surround the active zone of the photodiode (100, 300, 400).

7. Photodiode according to claim 6, wherein the inner walls (M1, M2, M3, Mi, Mn) are interconnected by one of the outer walls (110c).

8. Photodiode according to claim 6 or 7, wherein the outer walls (110a, 110b, 110c, 110d; 410a, 410b, 412a, 412b) entirely surround the active zone of the photodiode (100, 300, 400) .

9. Photodiode according to any one of claims 1 to 8, wherein the inner and lateral walls have a width, when viewed from above, comprised in the range of approximately 100 and approximately 300 nm.

10. Photodiode according to any one of claims 1 to 9, wherein the inner walls are separated from the closest inner or lateral walls by a distance equal to substantially five times their width, when viewed from above.
